(19) Europäisches Patentamt
European Patent Office
Office européen des brevets

(11) Publication number: **0 510 608 A1**

(12) **EUROPEAN PATENT APPLICATION**

(21) Application number: **92106875.5**

(22) Date of filing: **22.04.92**

(51) Int. Cl.$^5$: **C08L 83/04**, C09D 183/04

(30) Priority: **23.04.91 US 689439**

(43) Date of publication of application: **28.10.92 Bulletin 92/44**

(84) Designated Contracting States: **DE FR GB**

(71) Applicant: **DOW CORNING CORPORATION**
**P.O. Box 1767**
**Midland Michigan 48686-0994(US)**

(72) Inventor: **Houghtaling, Dawn Marie, Hensyn Village Apt.**
**Stedwick Drive, Building A, Apt. 3A**
**Budd Lake, New Jersey(US)**
Inventor: **Vanwert, Bernard**
**2159 Old Pine Trail**
**Midland, Michigan(US)**

(74) Representative: **Spott, Gottfried, Dr. et al**
**Spott Weinmiller & Partner**
**Sendlinger-Tor-Platz 11**
**W-8000 München 2(DE)**

(54) **One part, solventless, siloxane conformal coating.**

(57) A one-part, solventless silicone conformal coating for use in protecting printed circuits is obtained by mixing a diorganovinyl endblocked polydiorganosiloxane, an organosiloxane containing at least 3 silicone bonded hydrogen atoms per molecule, a platinum catalyst, an adhesion additive and a cure inhibitor. The adhesion additive is from 1.5 to 2 parts by weight of a mixture of a polysiloxane having both hydroxyl radicals and vinyl radicals and a silane having at least one epoxy-containing group and at least one silicon-bonded alkoxy group, the ratio of the first to the second of from 0.25 to 1.8 parts by weight. The cure inhibitor is less than 0.25 part by weight of an acetylenic Alcohol such as 3,5-dimethylhexyne-3-ol. The composition cures in 10 minutes at less than 100 ° C.

EP 0 510 608 A1

This invention relates to conformal coatings for circuit boards.

Silicone compositions based upon ethylenically unsaturated polydiorganosiloxane, organosilicone compound having silicon-bonded hydrogen atoms and a platinum catalyst are well known in the art. This cure system has been used to make resins and elastomers which cure at room temperature and with the application of heat. The system has been used to make both two part systems and when a cure inhibitor is present, one part systems. Adhesion of these materials to substrates has been poor.

Adhesion of silicone elastomers and resins to substrates has been a problem which has taken many forms. Priming a substrate prior to applying an uncured silicone elastomer composition is one solution. This two step process is inconvenient and expensive. Another approach is an additive to the elastomeric composition. Additives are usually specific for each composition, application and condition under which they are used. Most additives have shortcomings which prevent their use in more than a limited manner. Additives are developed to perform in each application as the need arises.

U.S. Patent No. 4,087,585, issued May 2, 1978, teaches an additive for use in a silicone composition containing vinyl-containing polydiorganosiloxane, organosilicon compound having an average of at least 3 silicon-bonded hydrogen atoms per molecule and a platinum catalyst. The additive is a combination of a polysiloxane having an average of at least one silicon-bonded hydroxyl radical per molecule and an average of at least one silicone-bonded vinyl radical per molecule and a silane having at least one epoxy-containing organo group and at least one silicon-bonded alkoxy group. The additive is used at a rate of from 0.1 to 5 parts per 100 parts of composition. There is from 0.25 to 1.8 parts by weight of the silane per part of the polysiloxane in the additive.

A one-part, heat curable, self-adhering solventless conformal coating is obtained from a composition comprising a product obtained by mixing a diorganovinyl endblocked polydiorganosiloxane, an organosilicone compound which acts as a crosslinker, a platinum catalyst, an adhesion additive and a cure inhibitor. The amount of adhesion additive and cure inhibitor must be controlled within narrow limits in order to obtain the required low cure temperature, shelf life and excellent adhesion to the substrate.

A composition comprising a product obtained by mixing (A) diorganovinyl endblocked polydiorganosiloxane, each organo radical being a monovalent radical selected from the group consisting of hydrocarbon radicals and fluorinated alkyl radicals both having less than 7 carbon atoms per radical, having a viscosity of greater than 0.3 Pa•s and less than 1 Pa•s at 25°C., (B) an organosilicon compound having an average of at least 3 silicon-bonded hydrogen atoms per organosilicon compound molecule and valences of any silicon atom in the organosilicon compound not satisfied by a hydrogen atom is satisfied by a divalent oxygen atom or an organo radical wherein each organo radical is a monovalent radical selected from the group consisting of hydrocarbon radicals and fluorinated alkyl radicals both having less than 7 carbons atoms per radical, the organosilicon compound having no more than one silicon-bonded hydrogen atom on any one silicon atom, (c) a platinum catalyst, (D) polysiloxane having an average of at least one silicon-bonded hydroxyl radical per molecule and an average of at least one silicon-bonded vinyl radical per molecule, the polysiloxane having siloxane units bonded through silicon-oxygen-silicon bonds and valences of each silicon atom in the polysiloxane are satisfied by at least one of monovalent alkyl radical having less than 7 carbon atoms per radical, phenyl radical, vinyl radical and hydroxyl radical and the remaining valences of silicon being satisfied by divalent oxygen atoms, the polysiloxane having an average of 15 or less silicon atoms per molecule, (E) a silane having at least one epoxy-containing organo group, at least one silicon-bonded alkoxy group having less than 5 carbon atoms per group and any remaining valences of the silane not satisfied by an epoxy-containing organo group or an alkoxy group is satisfied by a monovalent hydrocarbon radical or a fluorinated alkyl radical both having less than 7 carbon atoms per radical and (F) acetylinic alcohol, (A) and (B) being present in amounts sufficient to provide a mol ratio of silicon-bonded hydrogen atoms in (B) to silicon-bonded vinyl radical in (A) of 0.5 to 10, the combined weight of (D) and (E) being present in amounts of 1.5 to 2 parts by weight per 100 parts by weight of the composition exclusive of the weight of (D) and (E), (D) and (E) being present in a weight ratio of 0.25 to 1.8 parts by weight (E) per one part by weight (D) and (F) being present in an amount of less than 0.25 part by weight per 100 parts by weight of the composition; the composition being curable in 10 minutes at less than 100°C.

Silicone, solventless liquid compositions are used as conformal coatings for the protection of circuits and components on printed circuit boards. The coating should protect the components and circuits from the environment while being securely bonded to the components and the printed circuit board. It is necessary to be able to apply the composition and cure it for use without the necessity of elevated temperature cures, such as greater than 100°C., as many components and circuits are damaged by exposure to elevated temperatures. The composition needs to be of a low viscosity, such as less than 1 Pa•s at 25°C. so that the applied coating can be of the desired thickness, such as 3 micrometers.

The diorganovinyl endblocked polydiorganosiloxane, (A), has each organo radical being a monovalent radical selected from the group consisting of hydrocarbon radicals and fluorinated alkyl radicals both having less than 7 carbon atoms per radical. The organo radicals having less than 7 carbon atoms per radical are each selected from monovalent hydrocarbon radicals such as methyl, ethyl, vinyl, propyl, hexyl and phenyl and monovalent fluorinated alkyl radicals such as the perfluoroalkylethyl radicals including such species as 3,3,3-trifluoropropyl, beta-(perfluoroethyl)ethyl and beta-(perfluoropropyl)ethyl. Examples of (A) are dimethylvinylsiloxy endblocked polydimethylsiloxane, methylphenylvinylsiloxy endblocked polymethyl(3,3,3-trifluoropropyl)siloxane, dimethylvinylsiloxy endblocked polydiorganosiloxane copolymer of dimethylsiloxane units and methylphenylsiloxane units and methylphenylvinylsiloxy endblocked polydiorganosiloxane copolymer of methylsiloxane units and diphenylsiloxane units. The polyorganosiloxane can have siloxane units such as dimethylsiloxane units, methylphenylsiloxane units, diphenylsiloxane units, methyl(3,3,3-trifluoropropyl)siloxane units, methylethylsiloxane units, methylvinylsiloxane units, monomethylsiloxane units, monophenylsiloxane units, dimethylvinylsiloxane units, methylphenylvinylsiloxane units and $SiO_2$ units. Polyorganosiloxanes of (A) can be single polymers or mixtures of polymers. These polymers preferably have at least 50 percent of the organic radicals as methyl radicals. A preferred (A) is a dimethylvinylsiloxy endblocked polydimethylsiloxane. The polydiorganosiloxane of (A) has a viscosity of greater than 0.3 Pa•s and less than 1 Pa•s at 25°C. Using a polymer within this viscosity range gives a coating with sufficient toughness, but also of low enough viscosity that the desired coating thickness of about 3 micrometers is easily achieved as by dipping. A preferred viscosity is about 0.4 Pa•s at 25°C.

Organosilicon compound (B) is a silicone compound containing at least 3 silicon-bonded hydrogen atoms per molecule. The silicon-bonded hydrogen atoms should each be on different silicon atoms. However, certain preparations may result is some small amount of silicon atoms with two silicon-bonded hydrogen atoms per silicon atom. These materials are not excluded from use in the present invention inasmuch as their removal from the other species could be prohibitively expensive and no detrimental effects are known from the use of such mixtures. For practical purposes, the organosilicon compounds are those which are designed to have one silicon-bonded hydrogen atom per silicon atom.

The organosilicon compound, (B), can be any siloxane having an average of at least three silicon-bonded hydrogen atoms per molecule and an average of no more than one silicon-bonded hydrogen atom per silicon atom. The remaining valences of the silicon atoms are satisfied by divalent oxygen atoms or by monovalent radicals of alkyl having one to six carbon atoms per radical, such as methyl, ethyl, propyl, isopropyl, butyl, tertiary butyl, pentyl, hexyl, cyclohexyl or phenyl or 3,3,3-trifluoropropyl. The organohydrogen siloxanes can be homopolymers, copolymers and mixture thereof which contain siloxane units of the following types: $RSiO_{1.5}$, $R_2SiO$, $R_3SiO_{0.5}$, $RHSiO$, $HSiO_{1.5}$,$R_2HSiO_{0.5}$, $H_2SiO$, $RH_2SiO_{0.5}$ and $SiO_2$, where R is the monovalent radical defined above. Some specific examples include polymethylhydrogensiloxane cyclics, copolymers of trimethylsiloxy and methylhydrogensiloxane, copolymers of dimethylhydrogensiloxy and methylhydrogensiloxane, copolymers of trimethyl siloxy, dimethylsiloxane and methylhydrogensiloxane and copolymers of dimethylhydrogensiloxane, dimethylsiloxane and methylhydrogensiloxane. Preferably, the organohydrogensiloxanes have an average of at least five silicon-bonded hydrogen atoms per molecule. It is also preferred that (B) have less than 50 silicon atoms per molecule. Some additional species of organosilicone compounds, (B), can be found in U.S. Patent No. 3,697,473 which shows species within the scope of (B), but is not intended to limit the scope of (B). U.S. Patent No. 3,697,473 shows that in addition to species of (B) having at least 3 silicon-bonded hydrogen atoms, species which have 2 silicon-bonded hydrogen atoms can be combined with (B) for the attainment of specific properties.

Ingredients (A) and (B) are present in the compositions of this invention in amounts sufficient to provide a mol ratio of silicon-bonded hydrogen atoms to silicon-bonded vinyl radicals of 0.5 to 10. For the preparation of elastomeric compositions, the mol ratio of silicon-bonded hydrogen atoms in (B) to the silicon-bonded vinyl radicals in (A) is from 1 to 10 and for the preparation of gel-forming compositions the mol ratio of silicon-bonded hydrogen atoms in (B) to the silicon-bonded vinyl radicals in (A) is from 0.5 to 0.9.

The platinum catalyst,(C), can be any of the platinum catalysts known to catalyse the addition of silicon-bonded hydrogen atoms to silicon-bonded vinyl radicals. Platinum catalysts can be any of the known forms ranging from platinum as such or as deposited on carriers such as silica gel or powdered charcoal to platinic chloride, salts of platinum, chloplatinic acid and various complexes. Many of these platinum catalysts are described in U.S. Patent No. 3,696,473. One preferred class of platinum catalysts is described in U.S. Patent No. 3,419,593 which shows the preparation of this class of platinum catalyst and to show additional catalyst descriptions. The most preferred platinum catalyst described is a reaction product of chloroplatinic acid and a vinylsiloxane having at least two dimethylvinylsiloxy units per molecule and any

additional siloxane units being dimethylsiloxane. The platinum catalyst, (C), can be used in any catalytic quantity, such as in an amount sufficient to provide at least 0.1 part by weight platinum per one million parts by weight of (A), preferably at least one part by weight platinum per one million parts by weight (A) is used.

The polysiloxane,(D),is a siloxane having an average of 15 or less silicon atoms per molecule and containing one each per molecule of a silicon-bonded hydroxyl radical and a silicon-bonded vinyl radical. The valences of each silicon atom in (D) are satisfied by at least one of a monovalent alkyl radical having less than 7 carbon atoms per radical, phenyl radical, vinyl radical and hydroxyl radical with the remaining valences being satisfied by divalent oxygen atoms. (D) can have siloxane units, such as $R'SiO_{1.5}$, $R'_2SiO_{0.5}$, $CH_2=CHSiO_{1.5}$, $C_6H_5SiO_{1.5}$, $HOSiO_{1.5}$, $R'(CH_2=CH)SiO$, $R'(OH)SiO$, $R'(C_6H_5)SiO$, $(C_6H_5)_2SiO$, $(C_6H_5)(CH_2=CH)SiO$, $(C_6H_5)(OH)SiO$, $(CH_2=CH)(HO)SiO$, $(HO)R'_2SiO_{0.5}$, $(CH_2=CH)R'_2SiO_{0.5}$., $(HO)(CH_2=CH)R'SiO_{0.5}$ and $(HO)(C_6H_5)R'SiO_{0.5}$ where R' is a monovalent alkyl radical of less than 7 carbon atoms per radical, such as methyl, ethyl, propyl, hexyl and cyclohexyl. Preferably, (D) is a polysiloxane having hydroxyl siloxane units as end groups and the other siloxane units as diorganosiloxane units, where the preferred diorganosiloxane units are methylvinylsiloxane units and dimethylsiloxane units. (D) can be a mixture of one or more siloxane species. Some preferred species include hydroxyl endblocked polymethylvinylsiloxanes and hydroxyl endblocked polydiorganosiloxane copolymers of dimethylsiloxane units and methylvinylsiloxane units. Preferably, (D) has from 3 to 15 siloxane units.

The silane (E) is a molecule containing one silicon atom per molecule which has bonded thereto at least one epoxy-containing organo group, at least one silicon-bonded alkoxy group and any remaining valences are monovalent hydrocarbon radicals or monovalent fluorinated alkyl radicals. The alkoxy groups on (E) have less than 5 carbon atoms per group and are illustrated by methoxy, ethoxy, propoxy and butoxy. Both the monovalent hydrocarbon radicals and the fluorinated alkyl radicals have less than 7 carbon atoms per radical and are illustrated above in the description of (A). For the purpose of this invention, "epoxy" refers to the structural group

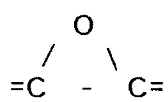

Many silanes of this type are known and are described in U.S. Patent No. 3,455,877 which shows the alkoxylated epoxy silanes and their preparation.

The silanes of (E) are preferably mono(epoxyorgano)trialkoxysilanes in which the epoxyorgano group is a radical of the formula as shown in U.S. Patent No. 4,087,585. The preferred (E) is a silane of the formula

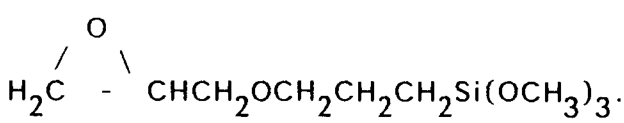

The weight range of (E) to (D) is within a range of 0.25 to 1.8 parts by weight of (E) per one part by weight of (D) to make the compositions of this invention. This weight ratio of (E) to (D) provides improved adhesion of the compositions when heat cured on substrates and used in amounts such that the combined weight of (D) and (E) is 1.5 to 2 parts by weight per 100 parts by weight of the composition exclusive of the weight of (D) and (E). The combined weight of (D) and (E) in the composition is preferably from 1.2 to 1.7 parts by weight and the preferred ratio of (E) to (D) is from 1 to 1.5 by weight (E) per one part by weight (D).

Component (F) is an acetylinic alcohol, added to aid in controlling the shelf life of the composition, while not lengthening the cure time excessively. The combination of vinyl containing polydiorganosiloxane, silicone-bonded hydrogen containing organosiloxane and platinum catalyst produces are curing system which operates at room temperature, so this must be controlled so that the composition does not begin to cure immediately upon mixing. The amount and kind of acetylinic alcohol are chosen to give the desired result in the composition. Acetylinic alcohols commonly used include benzyl alcohol and 3,5-dimethylhexyne-3-ol. The preferred inhibitor in the composition is 3.5-dimethylhexyne-3-ol in an amount of less than 0.25 part by weight per 100 parts by weight of the composition. The preferred amount is about 0.2 part.

The compositions can also contain pigments, colorants, flame retardant additives and plasticizers; as long as the additional ingredients do not interfere with the cure time or adhesion.

The compositions of this invention are particularly suited as coatings for printed circuits. They cure to a hard gel which bonds to the substrate, is hard enough to protect the components from the environment, but yet elastomeric enough so that the forces due to expansion differences in heating during use do not cause excessive strain of the components or the printed circuit board.

The following examples are included for illustrative purposes only and should not be construed as limiting the invention which is properly set forth in the appended claims.

Example 1

A series of mixtures were prepared and evaluated for shelf life, cure time and adhesion.

The amounts of the materials used in the mixtures are shown in Table I. The description of the different materials follows. The polymer used was a dimethylvinylsiloxy endblocked polydimethylsiloxane having a viscosity of about 0.4 Pa•s at 25°C. The organosilicon compound used as crosslinker was a trimethylsiloxy endblocked polydiorganosiloxane having an average of five methylhydrogensiloxane units and three dimethylsiloxane units per molecule with a silicon-bonded hydrogen atom content in the range of about 0.7 to 0.8 weight percent. The platinum catalyst was a chloroplatinic acid complex of divinyltetramethyldisiloxane diluted with dimethylvinylsiloxy endblocked polydimethylsiloxane to provide 0.7 weight percent platinum. The polysiloxane used for adhesion enhancement was a mixture of 100 parts of a polymethylvinylsiloxane with silicon-bonded hydroxyl radical in an amount of about 5 weight percent and an average of 7 to 10 methylvinylsiloxane units per molecule and 65 parts of glycidoxypropyltrimethoxysilane. An acetylinic alcohol sold under the trade name of Surfynol 61 by Air Products and Chemical Inc of Allentown, Pa. (3,5-dimethylhexyne-3-ol) and benzyl alcohol were ingredients, as was the adhesion promoter 1,2-Bis-(trimethoxysilyl)ethane, in some of the mixtures.

The various mixtures were evaluated for usefulness by measuring the shelf life, cure time and adhesion. The shelf life end point was considered the point at which the original viscosity doubled upon storage at room temperature. The cure time was established by placing a coated panel in an air-circulating open at a given temperature and checking periodically to find a time when it was no longer wet. The actual minimum cure time could be less than that shown. Adhesion was determined by first rubbing with the thumb, then if that was satisfactory, crosshatching with a razor blade and checking adhesion by placing SCOTCH brand adhesive tape over the crosshatch and removing it to observe how much of the crosshatched area was removed.

Table I

| Composition | Polymer | Crosslinker | Catalyst | Adhesion additive | Surfynol | Adhesion promoter | Benzyl Alcohol |
|---|---|---|---|---|---|---|---|
| | | | all parts by weight | | | | |
| A | 100 | 6.0 | 0.3 | 1.0 | 0.5 | -- | -- |
| B | 100 | 6.0 | 0.2 | 1.2 | 0.3 | -- | -- |
| C | 92 | 7.0 | 0.15 | 0.5 | 0.1 | -- | -- |
| D | 92 | 7.0 | 0.15 | 1.0 | 0.1 | -- | -- |
| E | 92 | 7.0 | 0.15 | 1.5 | 0.2 | -- | -- |
| F | 92 | 7.0 | 0.15 | 2.0 | 0.4 | -- | -- |
| G | 91 | 6.0 | 0.15 | 1.5 | 0.2 | 1.0 | -- |
| H | 89 | 6.0 | 0.15 | 1.5 | 0.2 | 3.0 | -- |
| I | 87 | 6.0 | 0.15 | 1.5 | 0.2 | 5.0 | -- |
| J | 88 | 6.0 | 0.15 | 1.5 | 0.2 | 3.0 | 0.2 |
| K | 88 | 6.0 | 0.15 | 1.5 | 0.2 | 3.0 | 0.3 |
| L | 92 | 6.0 | 0.15 | 1.5 | 0.2 | -- | -- |

| Composition | Shelf Life | Cure Time min./°C. | Adhesion |
|---|---|---|---|
| A | stable | 10/150 | good |
| B | good | 20/125 | good |
| C | 2 mo. | 10/125 | some |
| D | 2 mo. | 15/125 | fair |
| E | 6 mo. | 30/125 | very good |
| F | >6 mo. | 45/125 | very good |
| G | 6 mo. | 20/125 | very good |
| H | 6 mo. | 20/125 | very good |
| I | 6 mo. | 30/125 | spotty |
| J | 6 mo. | 15/100 | excellent |
| K | 6 mo. | 25/ 85 | excellent |
| | | 15/ 85 | |
| | | 7/100 | |
| L | -- | 10/110 | -- |

## Example 2

A series of compositions was prepared in which the amount of cure inhibitor and adhesion additive were varied to determine how to obtain both the desired rate of cure and desired adhesion at the same time.

The ingredients used are as in Example 1, except the adhesion additive had a ratio of 100 parts of the polymethylvinylsiloxane to 100 parts of the glycidoxypropyltrimethoxysilane, in the amounts shown in Table II. The results of the tests as described in Example 1 are shown in Table II.

Table II

| Sample | 1 | 2 | 3 |
|---|---|---|---|
| polymer | 100 | 100 | 100 |
| crosslinker | 6 | 6 | 6 |
| catalyst | .3 | .3 | .2 |
| adhesion additive | 1 | 1.2 | 1.5 |
| Surfynol 61 | 1 | .5 | .2 |
| Shelf Life, months | 6 | 5 | 3 |
| Cure Time, min./° C. | 10/150 | 10/125 | 10/105 |
| Adhesion | yes | yes | yes |

## Claims

**1.** A composition comprising a product obtained by mixing (A) diorganovinyl endblocked polydiorganosiloxane, each organo radical being a monovalent radical selected from the group consisting of hydrocarbon radicals and fluorinated alkyl radicals both having less than 7 carbon atoms per radical, having a viscosity of greater than 0.3 Pa•s and less than 1 Pa•s at 25° C., (B) an organosilicon compound having an average of at least 3 silicon-bonded hydrogen atoms per organosilicon compound molecule and valences of any silicon atom in the organosilicon compound not satisfied by a hydrogen atom is satisfied by a divalent oxygen atom or an organo radical wherein each organo radical is a monovalent radical selected from the group consisting of hydrocarbon radicals and fluorinated alkyl radicals both having less than 7 carbons atoms per radical, the organosilicon compound having no more than one silicon-bonded hydrogen atom on any one silicon atom, (C) a platinum catalyst, (D) polysiloxane having an average of at least one silicon-bonded hydroxyl radical per molecule and an average of at least one silicon-bonded vinyl radical per molecule, the polysiloxane having siloxane units bonded through silicon-oxygen-silicon bonds and valences of each silicon atom in the polysiloxane are satisfied by at least one of monovalent alkyl radical having less than 7 carbon atoms per radical, phenyl radical, vinyl radical and hydroxyl radical and the remaining valences of silicon being satisfied by divalent oxygen atoms, the polysiloxane having an average of 15 or less silicon atoms per molecule, (E) a silane having at least one epoxy-containing organo group, at least one silicon-bonded alkoxy group having less than 5 carbon atoms per group and any remaining valences of the silane not satisfied by an epoxy-containing organo group or an alkoxy group is satisfied by a monovalent hydrocarbon radical or a fluorinated alkyl radical both having less than 7 carbon atoms per radical and (F) acetylinic alcohol, (A) and (B) being present in amounts sufficient to provide a mol ratio of silicon-bonded hydrogen atoms in (B) to silicon-bonded vinyl radical in (A) of 0.5 to 10, the combined weight of (D) and (E) being present in amounts of 1.5 to 2 parts by weight per 100 parts by weight of the composition exclusive of the weight of (D) and (E), (D) and (E) being present in a weight ratio of 0.25 to 1.8 parts by weight (E) per one part by weight (D) and (F) being present in an amount of less than 0.25 part by weight per 100 parts by weight of the composition; the composition being curable in 10 minutes at less than 100° C.

European Patent Office

# EUROPEAN SEARCH REPORT

Application Number

EP 92 10 6875

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| P,X | EP-A-0 451 946 (DOW CORNING)<br>* claim 1 *<br>--- | 1 | C08L83/04<br>C09D183/04 |
| X,D | US-A-4 087 585 (SCHULZ)<br>* claim 1 *<br>----- | 1 | |

| TECHNICAL FIELDS SEARCHED (Int. Cl.5 ) |
|---|
| C08L<br>C09D |

The present search report has been drawn up for all claims

| Place of search | Date of completion of the search | Examiner |
|---|---|---|
| THE HAGUE | 30 JULY 1992 | LENTZ J.C. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document